# EUROPEAN PATENT APPLICATION

(11) **EP 1 698 651 A1**
(43) Date of publication of application: **06.09.2006**
(21) Application number: 04807366.2
(22) Date of filing: 20.12.2004
(51) Int. Cl.: C08G 73/16, G03F 7/027

(54) **POLYAMIDE ACID RESIN HAVING UNSATURATED GROUP, PHOTOSENSITIVE RESIN COMPOSITION USING SAME, AND CURED PRODUCT THEREOF**

(30) Priority: 22.12.2003 JP 2003424950
(71) Applicant: NIPPON KAYAKU KABUSHIKI KAISHA, Tokyo 102-8172 (JP)
(72) Inventor: AMISHIMA, Chika, Tokyo 1028172 (JP); TANAKA, Ryutaro, 1150042 (JP); KAMETANI, Hideaki, 1150042 (JP); KOYANAGI, Hiroo, 1750092 (JP)
(74) Representative: Gille Hrabal Struck Neidlein Prop Roos
(86) International application number: PCT/JP2004/019009
(87) International publication number: WO 2005/061586

(57) **Abstract**

The present invention provides a novel polyamide acid resin (A) containing an unsaturated group, suitable to a photosensitive resin composition, and a photosensitive resin composition using the same, which is excellent in photosensitivity, and the resultant cured product is excellent in flexibility as well as adhesiveness, pencil hardness, solvent resistance, acid resistance, heat resistance, gold plating resistance, and the like. Said polyamide acid resin (A) containing an unsaturated group is obtained by reacting an unsaturated group-containing polyester resin (a) having a terminal anhydride group, and a compound (b) having two amino groups in a molecule, and said photosensitive resin composition is obtained by reacting a resin composition containing said polyamide acid resin (A) containing an unsaturated group, a crosslinker (B) and a photopolymerization initiator (C).

## Description

### TECHNICAL FIELD

The present invention relates to a photosensitive resin composition using a polyamide acid resin containing an unsaturated group which can be developed using an alkaline aqueous solution, and a cured product thereof. In more detail, the present invention relates to a photosensitive resin composition which provides a cured product excellent in development characteristics flexibility, adhesiveness, soldering heat resistance, chemical resistance, plating resistance, and the like, and useful as a solder mask for a flexible printed-circuit board, an interlayer insulation film for a multilayer printed-circuit board, a photosensitive photo-waveguide, and the like, along with a cured product thereof.

### BACK GROUND ART

At present, a photocuring-type resin composition is used as a solder mask for a part of consumer printed-circuit boards and almost all industrial printed-circuit boards, in view of high accuracy and high integration, wherein image is formed by development treatment, after exposure using a photolithographic method, and further by finishing cure by means of heat and/or light irradiation. In addition, in consideration of environmental problems, an alkaline-development-type liquid solder mask is in the main stream, wherein a dilute alkaline aqueous solution is used as a development solution. As such an alkaline-development-type liquid solder mask, for example, a solder mask composition composed of a photosensitive resin, obtained by the adduct of an acid anhydride to a reaction product between a novolac-type epoxy resin and an unsaturated monobasic acid, a photopolymerization initiator, a crosslinker and an epoxy resin has been disclosed in patent reference 1.

In addition, flexibility is required to a solder mask applied to Ball Grid Array (hereinafter referred to as BGA) substrate or a flexible substrate. As this material, a composition using a compound obtained by reacting a reaction product of a multifunctional bisphenol-type epoxy resin having flexible structure, and (meth)acrylic acid, and a polybasic acid anhydride has been proposed in patent reference 2.
Patent reference 3 and patent reference 4 have proposed a photosensitive resin composition containing an unsaturated resin having a hydroxyl group, obtained by reacting 0.8 to 1.2 moles of an ethylenic unsaturated carboxylic acid with a number average molecular weight of 72 to 1000 and containing one carboxyl group in average and one ethylenic unsaturated group in average in one molecule, based on 1 mole of an epoxy group of a diepoxide, to improve flexibility, and a urethane resin containing an unsaturated group, obtained by reacting a diol compound containing a carboxyl group, a diisocyanate compound and, if necessary, a polyol compound.

In addition, a printed-circuit board has been required to have high accuracy and high integration, aiming at compact sizing and weight reduction, or enhanced communication speed of mobile device, and with this trend, requirement level to a solder mask has been increasingly higher, such as excellent performance in soldering heat resistance, electroless gold plating resistance, substrate adhesiveness, chemical resistance, and the like while maintaining more flexibility than conventional requirement, and several proposals have been made (patent reference 5, patent reference 6, patent reference 7, patent reference 8 and patent reference 9).
In addition, patent reference 10 has disclosed a resin composition suitable for an FPC etching resist or a cover lay, and a photosensitive resin composition using them. Said resin composition contains oligomers obtained by reacting a polyunsaturated polyol compound, which is obtained by reacting an epoxy resin having two epoxy groups in one molecule and a monocarboxylic acid having each one unsaturated double bond and a carboxyl group in one molecule, a diamine compound, and a polybasic acid anhydride having at least two acid anhydride groups in one molecule, and a film laminated with a photosensitive resin composition using said resin can be developed by a dilute alkaline solution, good in operability and the cured film thereof is excellent in flexibility and soldering heat resistance.
Said patent reference 10 provides the resultant oligomers in a form of an esterified polyamide acid resin, wherein three of said polyol, said diamine compound and said polybasic acid anhydride are randomly polymerized, or a diblock-type polymer of a reaction product between a diamine compound and said polybasic acid anhydride, and said polyunsaturated polyol compound, because three of said polyunsaturated polyol compound, diamine compound and polybasic acid anhydride having two acid anhydride groups in one molecule are reacted together, or a diamine compound and said polybasic acid anhydride are reacted in advance to yield a polyamide acid resin having a terminal acid anhydride group, and then said reaction product and said polyunsaturated polyol compound are reacted; and further it becomes an esterified polyamide acid resin having a terminal hydroxyl group, because said reaction is carried out under equivalent of said polybasic acid anhydride to be in a range of 0.05 to 0.95 equivalent, so that a hydroxyl group in said polyunsaturated polyol compound is left at the terminal. However, the resultant amide acid may partially be imidized, or may induce an isoimidization reaction depending on reaction temperature, because in this reaction, a step of the esterification reaction is carried out simultaneously with the amidation reaction, or at the later step, and therefore there is a defect that an esterified polyamide acid resin having acid value as designed can not be obtained.

Patent reference 1: JP-A-61-243869
Patent reference 2: JP No.2868190
Patent reference 3: JP-A-2001-33959
Patent reference 4: JP-A-2001-33960
Patent reference 5: JP-A-2002-138140
Patent reference 6: JP-A-2002338652
Patent reference 7: JP-A-2003-2958
Patent reference 8: JP-A-2003-43684
Patent reference 9: JP-A-2003-122001
Patent reference 10: WO 01/51991A1

### DISCLOSURE OF THE INVENTION

### (Problems to be solved by the present invention)

However, a cured product of a solder mask composition disclosed in patent reference 1 is hard, and application thereof to a BGA substrate or a flexible substrate widely used in such a field as recent mobile device, generates troubles of surface crack generation or no response to substrate folding. Use of material disclosed in patent reference 2 had a problem of insufficient flexibility and no response to extreme folding, although surface crack resistance was improved. Material disclosed in patent references 3 and 4 are good in flexibility, however, attainment of good balance among molecular weight, sensitivity and development characteristics is difficult, because, in view of resin designing, increase in molecular weight resulted in larger acid value of a resin, or increase in content of an ethylenic unsaturated group to enhance sensitivity lowered acid value of a resin, and a problem was still left in optimization of a soldering mask composition. In addition, compositions in patent references 5 to 10 are also not sufficient enough.
An object of the present invention is to provide a photosensitive resin composition, which can be subjected to fine image patterning responsive to high functionalization of a recent printed-circuit board, excellent in photosensitivity to activated energy rays, can form patterns by development using a dilute alkaline aqueous solution, as well as the resultant cured film by thermal curing in a post-cure step has sufficient flexibility, and suitable to a solder mask ink excellent in soldering heat resistance, electroless gold plating resistance, substrate adhesiveness, chemical resistance, and the like, along with a cured product thereof.

### (Means to solve the Problems)

The present inventors have intensively studied a way to solve the above-described problems and found that an estrified polyamide acid resin in the above-described patent reference 10 was a random copolymer of the above-described 3 components or a block-type polymer consisted of two components, namely a reaction product between a diamine compound and said polybasic acid anhydride, and said polyunsaturated polyol compound, and that it was an estrified polyamide acid resin having a terminal hydroxyl group, however, alternatively, a polyamide acid resin containing an unsaturated group, obtained by reacting the above-described polyunsaturated polyol compound and a tetrabasic acid dianhydride in advance, so that total equivalent of an anhydride group of a tetrabasic acid dianhydride is more than total equivalent of a hydroxyl group of said polyunsaturated polyol compound, to yield an unsaturated group containing polyester resin having a terminal anhydride group, and then reacting said polyester resin and a diamine compound at relatively mild temperature, is a block-type wherein a block of a polyester resin containing an unsaturated group is bonded with a diamine compound, and is suitable to a photosensitive resin composition, which is a object of the present invention, and a composition containing said polyamide acid resin containing a specified unsaturated group can solve the above-described problems, and have thus completed the present invention.

That is, the present invention relates to the following aspects:
(1) A polyamide acid resin (A) containing an unsaturated group, obtained by reacting an unsaturated group-containing polyester resin (a) having a terminal anhydride group with a compound (b) having two amino groups in a molecule,
(2) The polyamide acid resin (A) containing an unsaturated group according to (1), wherein an unsaturated group-containing polyester resin (a) having a terminal anhydride group is a compound obtained by reacting a polyol compound (c) containing an unsaturated group with a tetrabasic acid dianhydride (d),
(3) The polyamide acid resin (A) containing an unsaturated group according to (2), wherein a polyol compound (c) containing an unsaturated group is a compound obtained by reacting a compound (e) having at least two glycidyl groups in a molecule with a monocarboxylic acid (f) having an ethylenic unsaturated group in a molecule,
(4) The polyamide acid resin (A) containing an unsaturated group according to (3), wherein a compound (e) having at least two glycidyl groups in a molecule is (1) a bisphenol-type epoxy resin, (2) a straight chain or cyclic (C2 to C10) aliphatic polyvalent glycidyl ether, provided that number of a glycidyl group is 2 to 5, and number of carbon atoms in the case of a cyclic ether is at least 3, (3) a polysulfide type diglycidyl ether, or (4) a biphenol-type diepoxy compound, and in addition, a monocarboxylic acid (f) having an ethylenic unsaturated group in a molecule is a (C3 to C6) aliphatic monocarboxylic acid containing an ethylenic unsaturated group which may be substituted with a phenyl group,
(5) The polyamide acid resin (A) containing an unsaturated group according to (3), wherein a compound (e) having at least two glycidyl groups in a molecule is a compound selected from a group of a phenyl diglycidyl ether compound, a bisphenol-type diepoxy compound, a hydrogenated bisphenol-type diepoxy compound, a halogenated bisphenol-type diepoxy compound, an alicyclic diepoxy compound, an aliphatic diglycidyl ether compound, a polysulfide-type diglycidyl ether compound and a biphenol-type diepoxy compound,
(6) The polyamide acid resin (A) containing an unsaturated group according to (4) or (5), wherein a monocarboxylic acid (f) having an ethylenic unsaturated group in a molecule is (meth)acrylic acid or cinnamic acid,
(7) The polyamide acid resin (A) containing an unsaturated group according to (2) to (6), wherein a tetrabasic acid dianhydride (d) is a tetrabasic acid dianhydride selected from a group consisting of pyromellitic dianhydride, ethylene glycol-bis(anhydrotrimellitate), glycerin bis(anhydrotrimellitate) monoacetate, 1,2,3,4-butanetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, 3,3',4,4'-diphenylethertetracarboxylic dianhydride, 2,2-bis(3,4-anhydrodicarboxyphenyl)propane, 2,2-bis(3,4-anhydrodicarboxyphenyl)hexafluoropropane, 5-(2,5-dioxotetrahydro-3-furanyl)-3-methylcyclohexene-1,2-dicarboxylic anhydride, and 3a,4,5,9b-tetrahydro-5-(tetrahydro-2,4-dioxo-3-furanyl)-naphtho[1,2-c]furan-1,3-dione,
(8) The polyamide acid resin (A) containing an unsaturated group according to any one of (1) to (7), wherein a compound (b) having two amino groups in a molecule is a compound selected from a group consisting of 4,4'-diaminodiphenylmethane, 3,4'-diaminodiphenylmethane, 4,4'-diaminodiphenylether, 3,4'-diaminodiphenylether, 4,4'-diaminodiphenylsulfone, 3,4'-diaminodiphenylsulfone, 4,4'-diaminobenzophenone, and 3,4'-diaminobenzophenone,
(9) The polyamide acid resin (A) containing an unsaturated group according to any one of (1) to (6), wherein equivalent of an ethylenic unsaturated group of a polyamide acid resin (A) containing an unsaturated group is 300 to 2,000 g/equivalent,
(10) The polyamide acid resin (A) containing an unsaturated group according to any one of (1) to (8), wherein equivalent of a carboxyl group of a polyamide acid resin (A) containing an unsaturated group is 200 to 1,500 g/equivalent,
(11) A method for producing a polyamide acid resin (A) containing an unsaturated group according to any one of (1) to (10), characterized by reacting a polyol compound (c) containing an unsaturated group, which is a reaction product of a compound (e) having at least two glycidyl groups in a molecule and a monocarboxylic acid (f) having an ethylenic unsaturated group in a molecule, with a tetrabasic acid dianhydride (d) to yield an unsaturated group-containing polyester resin (a) having a terminal anhydride group, which is then reacted with a compound (b) having two amino groups in a molecule,
(12) The method for producing the polyamide acid resin (A) containing an unsaturated group according to (11), wherein a compound (e) having at least two glycidyl groups in a molecule is a bisphenol-type diepoxy compound, or a biphenol-type diepoxy compound; a monocarboxylic acid (f) having an ethylenic unsaturated group in a molecule is acrylic acid; a tetrabasic acid dianhydride (d) is pyromellitic anhydride or 3,3'4,4'-benzophenone tetracarboxylic dihydride; and a compound (b) having two amino groups in a molecule is 3,4'-diaminodiphenyl ether,
(13) A photosensitive resin composition characterized by containing the polyamide acid resin (A) containing an unsaturated group according to any one of (1) to (12), a crosslinker (B) and a photopolymerization initiator (C),
(14) The photosensitive resin composition characterized by containing the polyamide acid resin (A) containing an unsaturated group according to any one of (1) to (12), a crosslinker (B), a photopolymerization initiator (C), and a component (D) to be cured.
(15) A cured product of the photosensitive resin composition according to (13) or (14),
(16) A substrate having a layer of the cured product according to (15),
(17) An article having the substrate according to (16).

### (Effects of the Invention)

A polyamide acid resin (A) containing an unsaturated group of the present invention is characterized to be obtained by reacting an unsaturated group-containing polyester resin (a) having a terminal anhydride group with a compound (b) having two amino groups in a molecule. A photosensitive resin composition characterized by containing this polyamide acid resin (A) containing an unsaturated group, a crosslinker (B) and a photopolymerization initiator (C) is excellent in photosensitivity in forming a coating film by means of curing with irradiation of ultraviolet ray, and the resultant cured product sufficiently satisfies transparency, flexibility, adhesiveness, pencil hardness, solvent resistance, acid resistance, heat resistance, gold plating resistance, and the like. Therefore, said polyamide acid resin (A) is suitable as a component of a photosensitive resin composition for a printed-circuit board and a photosensitive resin composition for photo-waveguide formation, and the like.

### DETAILED DESCRIPTION OF THE INVENTION

### (Best Mode for Carrying Out the Invention)

A polyamide acid resin (A) containing an unsaturated group of the present invention is obtained by reacting an unsaturated group-containing polyester resin (a) having a terminal anhydride group with a compound (b) having two amino groups in a molecule. An unsaturated group-containing polyester resin (a) having a terminal anhydride group used here is obtained by reacting a polyol compound (c) containing an unsaturated group with a tetrabasic acid dianhydride (d), under such condition as total equivalent number of an anhydride group of a compound (d) to be used divided by total equivalent number of a hydroxyl group of a compound (c) is over 1, preferably 1.1 to 5, more preferably about 1.5 to 3, so that the terminal becomes an anhydride group.

A polyol compound (c) containing an unsaturated group is not especially limited as long as it has an unsaturated group in a molecule, however, a compound obtained by reacting a compound (e) having at least two glycidyl groups in a molecule, with a monocarboxylic acid (f) having an ethylenic unsaturated group in a molecule (hereinafter referred to as a compound (f)) is preferable, in particular, to enhance heat resistance in using as a composition, because it is considered to improve crosslinking density.

A compound (e) to be used here is not especially limited as long as it has at least two glycidyl groups in a molecule. For example, (1) a bisphenol-type epoxy resin (said epoxy resin includes A-type, F-type, S-type, and the like, and may be hydrogenated or halogenated), (2) a straight chained or cyclic aliphatic polyvalent glycidyl ether (for example, 1 to 2 ether bonds may be included in a straight chain or a ring, other than an ether bond of a glycidyl group, and in addition, carbon atoms of an aliphatic group is usually about 2 to 10, preferably about 2 to 8, and in the case of cyclic resin, it is at least 3. In addition, number of a glycidyl group is not especially limited, however, it is usually about 2 to 5 in average, preferably about 2 to 3 in average, and most preferably 2.), (3) a polysulfide-type diglycidyl ether, and (4) a biphenol-type diepoxy compound, and the like are included. Preferable one is a phenol-type diepoxy compound bonded with two phenol groups which may be substituted with a methyl group, and the like other than a hydroxyl group, directly as a single bond, or via a crosslinking group, for example, an alkylene group with carbon atoms of 1 to 3, which may be substituted with, for example, a halogen atom, or -SO₂-, and the like, including for example, a bisphenol-type epoxy resin, a biphenol-type diepoxy compound, and the like.
More specifically, phenyl diglycidyl ethers such as hydroquinone diglycidyl ether, catechol diglycidyl ether, and resorcinol diglycidyl ether; bisphenol type diepoxy compounds such as bisphenol-A-type epoxy resin, bisphenol-F-type epoxy resin, bisphenol-S-type epoxy resin, 2,2-bis(4-hydroxyphenyl)-1,1,1,3,3,3-hexafluoropropane-typ e epoxy resin; hydrogenated bisphenol-type diepoxy compounds such as hydrogenated bisphenol-A-type epoxy resin, hydrogenated bisphenol-F-type epoxy resin, hydrogenated bisphenol-S-type epoxy resin, and epoxy resin of hydrogenated 2,2-bis(4-hydroxyphenyl)-1,1,1,3,3,3-hexafluoropropane; halogenated bisphenol-type diepoxy compounds such as brominated bisphenol-A-type epoxy resin, and brominated bisphenol-F-type epoxy resin; alicyclic diepoxy compounds such as cyclohexane dimethanol diglycidyl ether; aliphatic diepoxy compounds such as 1,6-hexanediol diglycidyl ether, 1,4-butanediol diglycidyl ether, and diethyleneglycol diglycidyl ether; polysulfide-type diglycidyl ether compounds such as polysulfide diglycidyl ether; biphenol-type diepoxy compounds such as bixylenol-type epoxy resin; and the like are included. As specific ones, a bisphenol-A-type epoxy resin and a bixylenol-type epoxy resin are included.

As commercial products of these compounds (e), for example, the following trade names are included: A bisphenol-A- type epoxy resin such as Epikote 828, Epikote 1001, Epikote 1002, Epikote 1003 and Epikote 1004 (all produced from Japan Epoxy Resins Co., Ltd.), Epomic R-140, Epomic R-301 and Epomic R-304 (all produced from Mitsui Chemicals, Inc.), DER-331, DER-332, DER-324 (all produced from Dow Chemicals Co., Ltd.), Epiclon 840 and Epiclon 850 (all produced from Dainippon Ink & Chemicals, Inc.), UVR-6410 (produced from Union carbide Corp.) and YD-8125 (produced from Tohto Kasei Co., Ltd.); a bisphenol-F-type epoxy resin such as UVR-6490 (produced from Union carbide Corp.), YDF-2001, YDF-2004 and YDF 8170 (all produced from Tohto Kasei Co., Ltd.), Epiclon 830 and Epiclon 835 (all produced from Dainippon Ink & Chemicals, Inc.); a hydrogenated bisphenol-A-type epoxy resin such as HBPA-DGE (produced from Maruzen Petrochemical Co. , Ltd.) and Rikaresin HBE-100 (produced from New Japan Chemical Co., Ltd.); a brominated bisphenol-A type epoxy resin such as DER-513, DER-514 and DER-542 (all produced from Dow Chemicals Co., Ltd.); an alicyclic diepoxy compound such as Celloxide 2021 (produced from Daicel Chemical industries, Ltd.), Rikaresin DME-100 (produced from New Japan Chemical Co. , Ltd.) and EX-216 (produced from Nagase Chemtex Corp.); an aliphatic diglycidyl ether compound such as ED-503 (produced from Asahi Denka Co. , Ltd.), Rikaresin W-100 (produced from New Japan Chemical Co., Ltd.), EX-212, EX-214 and EX-850 (all produced from Nagase ChemteX Corp.); a polysulfide-type diglycidyl ether compound such as FLEP-50, FLEP-60 (all produced from Toray Finechemicals Co., Ltd.); and a bixylenol-type epoxy resin such as YX4000 (produced from Japan Epoxy Resins Co. , Ltd.).

In addition, a monocarboxylic acid (f) having an ethylenic unsaturated group in a molecule is used to be reacted with the above-described compound (e), to obtain a polyol compound (c) containing an unsaturated group. Said (f) is not especially limited in use as long as it is a monocarboxylic acid having an ethylenic unsaturated group in a molecule, however, it is preferably an aliphatic monocarboxylic acid containing an ethylenic unsaturated group with carbon atoms of the aliphatic group of about 3 to 6, preferably about 3 to 5, which may be substituted with a phenyl group, and the like, and further preferably (meth)acrylic acid which may have a phenyl substitution. (Meth)acrylic acid or cinnamic acid is particularly preferable to enhance photosensitivity in using as a composition. In addition, (meth)acrylic acid in the present specification means that it may be any of acrylic acid or methacrylic acid.

A reaction between a compound (e) and a compound (f) can be carried out in non-solvent or in an organic solvent or, as described later, in a single or mixed organic solvent of a crosslinker (B), and the like. Use ratio in a reaction between a compound (e) having at least two glycidyl groups in a molecule, and a monocarboxylic acid (f) having an ethylenic unsaturated group in a molecule, is not especially limited, however, a compound (f) is preferably used in about 0.5 to 2.0 equivalent, more preferably 1 to 1.5 equivalent, as equivalent of a carboxyl group thereof, based on 1 equivalent of a glycidyl group of a compound (e). Reaction temperature may be selected, as appropriate, depending on raw material to be used, however, it is usually about 50 to 200ºC, preferably about 60 to 150ºC, and further preferably about 80 to 130ºC.

As an organic solvent, for example, amides such as N-methylpyrrolidone, and dimethylacetamide; ketones such as acetone, ethyl methyl ketone, and cyclohexanone; aromatic hydrocarbons such as benzene, toluene, xylene, and tetramethylbenzene; glycol ethers such as ethylene glycol dimethyl ether, ethylene glycol diethyl ether, dipropylene glycol dimethyl ether, dipropylene glycol diethyl ether, triethylene glycol dimethyl ether, and triethylene glycol diethyl ether; esters such as ethyl acetate, butyl acetate, methyl cellosolve acetate, ethyl cellosolve acetate, butyl cellosolve acetate, carbitol acetate, propylene glycol monomethyl ether acetate, dialkyl glutamate, dialkyl succinate, and dialkyl adipate; cyclic ethers such as γ-butyrolactone; petroleum solvents such as petroleum ether, petroleum naphtha, hydrogenated petroleum naphtha, and solvent naphtha; and the like are included.

A thermal polymerization inhibitor is preferably added to suppress a thermal polymerization reaction, in a reaction of a compound (e) and a compound (f), and use amount of a thermal polymerization inhibitor is 0.05 to 10% by weight, preferably 0.1 to 5% by weight, based on a reaction product. As a thermal polymerization inhibitor which can be used, hydroquinone, 2-methyhydroquinone, hydroquinone monomethyl ether, 2,6-di-tert-butyl-p-cresol, and the like are included.

A catalyst is preferably used to promote a reaction of a compound (e) and a compound (f) at the time of the reaction, and use amount of said catalyst is 0.1 to 10% by weight, preferably 0.2 to 5% by weight, based on a reaction product. Reaction temperature here is 60 to 150ºC, preferably 80 to 130ºC, and reaction time is 3 to 60 hours, preferably 5 to 40 hours. As a catalyst which can be used in this reaction, for example, dimethylaminopyridine, triethylamine, benzyl dimethyl amine, triethyl ammonium chloride, benzyl trimethyl ammonium bromide, benzyl trimethyl ammonium iodide, triphenyl phosphine, triphenyl stibine, methyl triphenyl stibine, chromium 2-ethylhexanoate, chromium octanoate, zinc 2-ethylhexanoate, zinc octanoate, zirconium octanoate, dimethyl sulfide, diphenyl sulfide, and the like are included.
A more preferable polyol compound (c) containing an unsaturated group is a polyol compound (c) containing an unsaturated group, obtained from a bisphenol-A-type epoxy resin or a bixylenol-type epoxy resin (an (e) component) and (meth)acrylic acid (as an (f) component) which may substituted
with a phenyl group.

An unsaturated group-containing polyester resin (a) having a terminal anhydride group is obtained by reacting a polyol compound (c) containing an unsaturated group obtained above, with a tetrabasic acid dianhydride (d), under such condition as total equivalent number of an anhydride group of a compound (d) to be used divided by total equivalent of a hydroxyl group of a compound (c) is over 1, preferably 1.1 to 5, more preferably about 1.5 to 3, so that the terminal becomes an anhydride group.
A tetrabasic acid dianhydride (d) to be used here is not especially limited, however, for example, a dianhydride of a (C6 to C18) aromatic tetracarboxylic acid, a dianhydride of a (C4 to C12) aliphatic tetracarboxylic acid, a dianhydride of a tetracarboxylic acid obtained by bonding, directly or via a crosslinking group, two (C2 to C10) hydrocarbon dicarboxylic acids having two carboxyl groups at adjacent sites, more preferably a dianhydride of a tetracarboxylic acid obtained by bonding, directly or via a crosslinking group, two phenyl groups having two carboxyl groups at adjacent sites, and the like are included. A crosslinking group here includes an alkylene group having carbon atoms of 1 to 4, -O-, -SO₂-, -CO-, -CO-O- (an alkylene group having carbon atoms of 1 to 4)-O-CO-, and the like. In addition, the above alkylene group having carbon atoms of 1 to 4 may be branched, or may have a substituent such as a halogen atom, a hydroxyl group, an acetyloxy group, and the like. In addition, an aliphatic group having carbon atoms of 4 to 12 in the dianhydride of an aliphatic tetracarboxylic acid having carbon atoms of 4 to 12 may be straight chained or cyclic. It may also be such one as obtained by bonding cyclic aliphatic groups directly or via the above crosslinking group.
In addition, the above phenyl group may further have a substituent, in some cases. Specifically, pyromellitic dianhydride, ethylene glycol-bis(anhydrotrimellitate), glycerin bis(anhydrotrimellitate) monoacetate, 1,2,3,4-butanetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, 3,3',4,4'-diphenylethertetracarboxylic dianhydride, 2,2-bis(3,4-anhydrodicarboxyphenyl)propane, 2,2-bis(3,4-anhydrodicarboxyphenyl)hexafluoropropane, 5-(2,5-dioxotetrahydro-3-furanyl)-3-methylcyclohexene-1,2-dicarboxylic anhydride, 3a,4,5,9b-tetrahydro-5-(tetrahydro-2,4-dioxo-3-furanyl)-naphtho[1,2-c]furan-1,3-dione, and the like are included as preferable examples. More preferable ones are pyromellitic anhydride and a dianhydride of a tetracarboxylic acid obtained by bonding, directly or via a crosslinking group, two (C2 to C10) hydrocarbon dicarboxylic acids having two carboxyl groups at adjacent sites.

A reaction of a compound (c) and a compound (d) can be carried out in the above-described solvent. Reaction temperature here is 60 to 150ºC, preferably 80 to 130ºC, and reaction time is 3 to 12 hours, preferably 5 to 10 hours. A catalyst can be used to promote a reaction, however, the new addition is not necessary particularly, because a catalyst used in producing a compound (c) can be applied as it is.
An unsaturated group-containing polyester resin (a) having a terminal anhydride group, obtained by reacting the above more preferable compound (c) with the above more preferable tetrabasic acid dianhydride (d), is a more preferable compound.

A polyamide acid resin (A) containing an unsaturated group of the present invention can be obtained by reacting an unsaturated group-containing polyester resin (a) having a terminal anhydride group, with a compound (b) having two amino groups in a molecule. Said polyamide acid resin (A) has a carboxyl group and an amide group formed by an adduct of a compound (b) to an anhydride group of a compound (a).
As a compound (b) to be used in synthesis of said polyamide acid resin (A), any compound can be used as long as it has two amino groups in a molecule, for example, an aliphatic hydrocarbon compound having carbon atoms of 1 to 13, or an aromatic hydrocarbon compound having carbon atoms of 5 to 13, both having two amino groups directly or via a crosslinking group, a diphenyl compound obtained by bonding, directly or via a crosslinking group, two phenyl groups having 1 amino group directly or via a crosslinking group, and the like are included. A crosslinking group of an amino group is not especially limited, and those exemplified later at an item of a crosslinking group of a phenyl group can be used. A crosslinking group for bonding two phenyl groups includes an alkylene group having carbon atoms of 1 to 6, -O- , -S-, -SO₂-, -SO-, -CO-, -C₆H₄-CO-C₆H₄-, -C₆H₄-CONH-C₆H₄-, -NH-, and the like .
The above compound (b) (diamine) may have an amino group or a substituent other than a crosslinking group having an amino group, such as a halogen atom, as a substituent.
A diaminodiphenyl compound obtained by bonding an amino substituted phenyl group, directly as a single bond or via a crosslinking group, is preferable in view of easy availability on the market, and the like, and a preferable crosslinking group includes an alkylene group having carbon atoms of 1 to 6, -O-, -SO₂- or -CO-, and the like. A more preferable crosslinking group includes a methylene group or -O-.
As preferable compounds easily available on the market, 4,4'-diaminodiphenyl methane, 3,4'-diaminodiphenyl methane, 4,4'-diaminodiphenyl ether, 3,4'-diaminodiphenyl ether, 4,4'-diaminodiphenyl sulfone, 3,4'-diaminodiphenyl sulfone, 4,4'-diaminobenzophenone, or 3,4'-diaminobenzophenone are included, and 3,4'-diaminodiphenyl ether or 4,4'-diaminodiphenyl methane is more preferable.
In the above reaction, use amount of a compound (b) having two amino groups in a molecule is, for example, 0.7 to 2 moles (1.4 to 4 equivalent as equivalent of an amino group), preferably 0.8 to 1.5 moles (1.6 to 3 equivalent as equivalent of an amino group), more preferably 0.9 to 1.2 moles (1.8 to 2.4 equivalent as equivalent of an amino group), based on 2 equivalent of an anhydride group of an unsaturated group-containing polyester resin (a) having a terminal anhydride group, and usually about 1 mole is used.

As reaction conditions between an unsaturated group-containing polyester resin (a) having a terminal anhydride group and a compound (b) having two amino groups in a molecule, conditions generally well-known to obtain a polyimide precursor can be applied as they are. For example, in the above-described solvent, an unsaturated group-containing polyester resin (a) having a terminal anhydride group, and a compound (b) having two amino groups in a molecule are mixed and reacted at a temperature of -10 to 60ºC, preferably 5 to 50ºC. In addition, reaction time is 3 to 48 hours, and preferably 5 to 30 hours. In this case, excessively high temperature partially promotes imidization and loses carboxyl groups, resulting in decreased development characteristics in using as a composition, and therefore should be cautious.

Equivalent of an ethylenic unsaturated group of a polyamide acid resin (A) containing an unsaturated group of the present invention is not determined simply, because it largely differs depending on raw material used, and the like, however, 300 to 2,000 g/equivalent is preferable, and 350 to 800 g/equivalent is more preferable, in consideration of flexibility and photosensitivity. This equivalent below 300 g/equivalent or over 2,000 g/equivalent may increase crosslinking density too high, or, in contrary, may decrease photosensitivity too low, and therefore should be cautious.

Equivalent of a carboxyl group of a polyamide acid resin (A) containing an unsaturated group is not determined simply, because it largely differs depending on raw material used, and the like, however, 200 to 1,500 g/equivalent is preferable, and 200 to 600 g/equivalent is more preferable, in view of development characteristics. Usually about 250 to 500 g/equivalent is optimally used.

A photosensitive resin composition of the present invention is characterized by containing a polyamide acid resin (A) containing an unsaturated group, a crosslinker (B) and a photopolymerization initiator (C).

As a crosslinker (B) to be contained in a photosensitive resin composition of the present invention, any crosslinker can be used as long as it is one generally used in a photosensitive resin composition, and includes a compound having two or more reactive functional groups, for example, a hydroxyl group, acryloyl group or a glycidyl group, and a (meth)acrylic acid derivative is preferable. The crosslinker (B) can be used alone or as a mixture form of two or more kinds. A specific (meth)acrylic acid derivative includes (i) an ester between a polyvalent alcohol and (meth)acrylic acid, for example, (1) an ester (one or more hydroxyl groups are enough to be esterified, and all of them may be esterified) between a polyvalent alcohol having carbon atoms of 2 to 20 and having 2 to 10, preferably 2 to 8 hydroxyl groups (ether bonds may be included in the carbon chain) and (meth)acrylic acid, (2) a mono- or diester between a (C2 to C4) polyalkylene glycol and (meth)acrylic acid, (3) an ester between an ε -caprolactone adduct of the above-described polyvalent alcohol and (meth)acrylic acid, or (4) a half ester, which is a reaction product between a (meth)acrylate containing a hydroxyl group, and an acid anhydride of a polycarboxylic acid compound, or (ii) an epoxy (meth)acrylate, which is a reaction product between a mono- or polyglycidyl compound and (meth)acrylic acid, and the like.
As specific examples of the above-described (1) to (3) of (i), 2-hydroxyethyl (meth)acrylate, 2-hydroxypropyl (meth)acrylate, 1,4-butanediol mono(meth)acrylate, carbitol (meth)acrylate, polyethyleneglycol di(meth)acrylate, tripropyleneglycol di(meth)acrylate, trimethylolpropane tri(meth)acrylate, trimethylolpropane polyethoxytri(meth)acrylate, glycerin polypropoxy tri(meth)acrylate, di(meth)acrylate of ε- caprolactone adduct with neopentylglycol hydroxypivalate (for example, trade name: KAYARAD HX-220, HX-620, and the like, produced from Nippon Kayaku Co. Ltd.,); pentaerythritol tetra(meth)acrylate, poly(meth)acrylate which is a reaction product of dipentaerythritol and ε -caprolactone; dipentaerythritol poly(meth)acrylate, and the like can be included.
Among these crosslinker (B), (i) an ester between a polyvalent alcohol and (meth)acrylic acid, in particular, (1) an ester (one or more hydroxyl groups are enough to be esterified, and all of them may be esterified) between a polyvalent alcohol having carbon atoms of 2 to 20 and having 2 to 10, preferably 2 to 8 hydroxyl groups (ether bonds may be included in the carbon chain) and (meth)acrylic acid is one of more preferable ones.

As a (meth)acrylate containing a hydroxyl group in the half ester, which is a reaction product between a (meth)acrylate containing a hydroxyl group, and an acid anhydride of a polycarboxylic acid compound of above-describe (4), an ester between the above-described polyvalent alcohol and (meth)acrylic acid, which have a hydroxyl group, is included. For example, 2-hydroxyethyl (meth)acrylate, 2-hydroxypropyl (meth)acrylate, 1,4-butanediol mono(meth)acrylate, and the like are included.
As an acid anhydride of a polycarboxylic acid compound, an anhydride of a C1 to C6 aliphatic di- or tetracarboxylic acid or an anhydride of a C5 to C10 aromatic di- or tetracarboxylic acid, and the like are included, and for example, succinic anhydride, maleic anhydride, phthalic anhydride, tetrahydrophthalic anhydride, hexahydrophthalic anhydride, and the like are included.

As a mono- or polyglycidyl compound in epoxy (meth)acrylate, namely a reaction product between mono- or polyglycidyl compound and (meth)acrylic acid, in the above-described (ii), a glycidyl ether of a C1 to C10 aliphatic alcohol, a glycidyl ether of the above-described polyvalent alcohiol, a glycidyl ether of phenols (which may have multiple, for example 2 to 3, hydroxyl groups), for example, butyl glycidyl ether, phenyl glycidyl ether, polyethylene glycol diglycidyl ether, polypropylene glycol diglycidyl ether, 1,6-hexanediol diglycidyl ether, diglycidyl hexahydrophthalate, glycerin polyglycidyl ether, glycerin polyethoxy glycidyl ether, trimethylolpropane polyglycidyl ether, trimethylolpropane polyethoxy polyglycidyl ether, and the like are included.
As other (meth)acrylic acid derivative in the above (iii), acryloylmorpholine, and the like are included.

As a photopolymerization initiator (C) contained in a photosensitive resin composition of the present invention, for example, benzoins such as benzoin, benzoin methyl ether, benzoin ethyl ether, benzoin propyl ether, benzoin isobutyl ether; acetophenones such as acetophenone, 2,2-diethoxy-2-phenylacetophenone, 1,1-dichloroacetofenone, 2-hydroxy-2-methyl-phenylpropane-1-one, diethoxyacetofenone, 1-hydroxycyclohexyl phenyl ketone, 2-methyl-1-[4-(methylthio)phenyl]-2-morpholino-propane-1-one; anthraquinones such as 2-ethylanthraquinone, 2-tertiary-butylanthraquinone, 2-chloroanthraquinone, 2-aminoanthraquinone; thioxanthones such as 2,4-diethylthioxanthone, 2-isopropylthioxanthone, 2-chlorothioxanthone; ketals such as acetophenone dimethylketal, benzyl dimethylketal; benzophenones such as benzophenone, 4-benzoyl-4'-methyldiphenylsulfide, 4,4'-bismethylaminobenzophenone; phosphine oxides such as 2,4,6-trimethylbenzoyldiphenylphosphine oxide, bis(2,4,6-trimethylbenzoyl)-phenylphosphine oxide, and the like are included.

A photopolymerization initiator (C) can be used alone or in a mixture form of two or more kinds, and further by combination of an accelerator including tertiary amines such as triethanolamine, and methyldiethanolamine; benzoic acid derivatives such as ethyl N,N-dimethylaminobenzoate, and isoamyl N,N-dimethylaminobenzoate, and the like.

To a photosensitive resin composition of the present invention, a component (D) to be cured can also be added as an arbitrary component. As a component (D) to be cured, for example, an epoxy resin, an oxazine compound, and the like are included. A component (D) to be cured reacts, by heating, with a carboxyl group or a hydroxyl group remaining in a resin coating film after photocuring, and is particularly preferably used to obtain a cured coating film having further strong chemical resistance.

As an epoxy resin as a component (D) to be cured, for example, a phenol-novolac-type epoxy resin, a cresol-novolac-type epoxy resin, a trishydroxyphenylmethane-type epoxy resin, a dicyclopentadiene-phenol-type epoxy resin, a bisphenol-A-type epoxy resin, a bisphenol-F-type epoxy resin, a biphenol-type epoxy resin, a bisphenol-A-novolac-type epoxy resin, an epoxy resin containing naphthalene skeleton, an alicyclic epoxy resin, a heterocyclic epoxy resin, and the like are included.

As a phenol-novolac-type epoxy resin, for example, Epiclon N-770 (produced from Dainippon Ink & Chemicals, Inc.), D.E.N438 (produced from Dow Chemicals Co., Ltd.), Epikote 154 (produced from Japan Epoxy Resins Co. , Ltd.), RE-306 (produced from Nippon Kayaku Co., Ltd.), and the like are included. As a cresol-novolac-type epoxy resin, for example, Epiclon N-695 (produced from Dainippon Ink & Chemicals, Inc.), EOCN-102S, EOCN-103S andEOCN-104S(all produced from Nippon Kayaku Co., Ltd.), UVR-6650 (produced from Union Carbide Corp.), ESCN-195 (produced from Sumitomo Chemical Co. , Ltd.), and the like are included.

As a trishydroxyphenylmethane-type epoxy resin, for example, EPPN-503, EPPN-502H, EPPN-501H (all produced from Nippon Kayaku Co., Ltd.), TACTIX-742 (produced from Dow Chemicals Co., Ltd.), Epikote E1032H60 (produced from Japan Epoxy Resins Co., Ltd.), and the like are included. As a dicyclopentadienephenol-type epoxy resin, for example, Epiclon EXA-7200 (produced from Dainippon Ink & Chemicals, Inc.), TACTIX-556 (produced from Dow Chemicals Co. , Ltd.), and the like are included.

As a bisphenol-A-type epoxy resin, for example, Epikote 828 and Epikote 1001 (all produced from Japan Epoxy Resins Co. , Ltd.), UVR-6410 (produced from Union carbide Corp.), D.E.R-331 (produced from Dow Chemicals Co., Ltd.), YD-8125 (produced from Tohto Kasei Co., Ltd.), and the like are included. As a bisphenol-F-type epoxy resin, for example, UVR-6490 (produced from Union Carbide Corp.), YDF-8170 (produced from Tohto Kasei Co., Ltd.), and the like are included.

As a biphenol-type epoxy resin, for example, NC-3000 and NC-3000H (all produced from Nippon Kayaku Co. , Ltd.), and the like are included. As a bixylenol-type epoxy resin, for example, YX4000, YL-6121 (all produced from Japan Epoxy Resins Co., Ltd.), and the like are included. As a bisphenol-A-novolac-type epoxy resin, for example, Epiclon N-880 (produced from Dainippon Ink & Chemicals, Inc.), Epikote E157S75 and XY8000 (all produced from Japan Epoxy Resins Co. , Ltd.), and the like are included.

As an epoxy resin having naphthalene skeleton, for example, NC-7000 and NC-7300 (all produced from Nippon Kayaku Co. , Ltd.), EXA-4750 (produced from Dainippon Ink & Chemicals, Inc.), and the like are included. As an alicyclic epoxy resin, for example, EHPE-3150 (produced from Daicel Chemical Industries, Ltd.), and the like are included. As a heterocyclic epoxy resin, for example, TEPIC (produced from Nissan Chemical Industries, Ltd.), and the like are included.

An oxazine compound as a component (D) to be cured, for example, B-m-type benzoxazine, P-a-type benzoxazine and B-a-type benzoxazine (all produced from Shikoku Chemicals Corp.), and the like are included.

A photosensitive resin composition of the present invention can be obtained by mixing a polyamide acid resin (A) containing an unsaturated group, of the present invention, a crosslinker (B), a photopolymerization initiator (C) and a component (D) to be cured, as an arbitrary component, along with other additives. Use mounts of (A), (B), (C) and (D), along with other additives contained in a photosensitive resin composition of the present invention are as follows, based on nonvolatile contents of a photosensitive resin composition as 100% by weight: (A) component is usually 10 to 80% by weight, preferably 15 to 45% by weight; (B) component is usually 2 to 60% by weight, preferably 5 to 20% by weight; (C) component is usually 0.1 to 30% by weight, preferably 1 to 10% by weight; and the remainder is consisted of other components (hereinafter referred to as "other components") usually used in a photosensitive resin composition, selected from a group consisting of a component (D) to be cured and other additives; (D) component in said photosensitive resin composition is usually 0 to 30% by weight, preferably 5 to 20% by weight; and the remainders are other additives.

As the above-described other additives, various additives added arbitrarily can be added to enhance various performances of a composition, for example, thermal curing catalysts such as melamine; fillers such as talc, barium sulfate, calcium carbonate, magnesium carbonate, barium titanate, aluminum hydroxide, aluminum oxide, silica, and clay; thixotropy furnishing agents such as aerosol; colorants such as phthalocyanine blue, phthalocyanine green, titanium oxide and pigments; leveling agents or antifoaming agents such as silicone and fluorine-based compounds; polymerization inhibiters such as hydroquinone, hydroquinone monomethyl ether; and the like

In the case when the above-described component to be cured is used, it may be blended to the above-described resin composition in advance, or may be used by mixing before application to a printed-circuit board. Namely, it is a method for formulating a two-pots system, using the above-described component (A) as a main component, composed of a major component solution formulated with an epoxy curing promoter thereto, and a solution of a component to be cured, mainly containing a component to be cured, and both solutions are mixed just before use.

A photosensitive resin composition of the present invention can also be used as a dry-film-type solder mask having structure wherein a resin composition is sandwiched between a supporting film and a protection film.

A photosensitive resin composition (liquid or film state) of the present invention is useful as resist material such as interlayer insulation material of electronics parts, a solder mask for a photo-waveguide connecting photonic parts or a printed-circuit board, or a cover lay, or can also be used as color filters, printing ink, sealants, paints, coating material, adhesives, and the like.

A cured product of a photosensitive resin composition of the present invention is one produced by curing a photosensitive resin composition of the present invention by means of irradiation of energy ray such as ultraviolet ray, and curing can be carried out by a usual method for irradiation of energy ray such as ultraviolet ray. For example, in irradiation of ultraviolet ray, ultraviolet ray generation equipment such as a low pressure mercury lamp, a high pressure mercury lamp, an ultra-high pressure mercury lamp, a xenon lamp, an ultraviolet ray emission laser (an excimer laser, and the like) may be used.

A substrate having a layer of a cured product of the present invention is a substrate having a layer-like cured product of a photosensitive resin composition cured by irradiation of energy ray such as ultraviolet ray, and includes, for example, a resist film, interlayer insulation material for a build-up construction method, or a printed-circuit board as a photo-waveguide, electric/electronics/optical parts such as a photoelectron-substrate or a photo-substrate. Articles of the present invention having these substrates include, for example, computer, electric appliance and mobile device, and the like. Film thickness of the cured product layer is about 0.5 to 160 µm, and about 1 to 100 µm is preferable.

A printed-circuit board using a photosensitive resin composition of the present invention can be obtained, for example, as follows: Namely, in the case of using a liquid resin composition, a composition of the present invention is applied on a printed-circuit board in a film thickness of 5 to 160 µm, preferably 10 to 100 µm, by means of a method such as screen coating, spray coating, roll coating, electrostatic coating, curtain coating and bar coating, and then by drying the coating film at a temperature of usually 50 to 110ºC, preferably 60 to 100ºC, for 10 to 90 minutes, preferably 30 to 60 minutes, a coating film can be formed. Subsequently, the coating film is directly or indirectly irradiated by high energy ray such as ultraviolet ray in an intensity of usually 10 to 2000 mJ/cm², preferably 300 to 1000 mJ/cm², through a photo mask formed with exposure patterns, such as a negative film, and then unexposed area is developed using a development solution described later, for example, by spraying, shake-immersing, brushing, scrubbing, and the like. Then, if necessary, by further irradiation of ultraviolet ray and subsequent heat treatment usually at a temperature of 100 to 400ºC, preferably 140 to 300ºC, for 0.5 to 5 hours, preferably 0.8 to 3 hours, a printed-circuit board having a permanent protective film, and having excellent flexibility as well as satisfying various characteristics such as transparency, adhesiveness, pencil hardness, solvent resistance, acid resistance, heat resistance and gold plating resistance can be obtained.

As the above-described alkaline aqueous solution which can be used as a development solution, an inorganic alkaline aqueous solution such as potassium hydroxide, sodium hydroxide, sodium carbonate, potassium carbonate, sodium hydrogen carbonate, potassium hydrogen carbonate, sodium phosphate, and potassium phosphate; and an organic alkali aqueous solution such as tetramethyl ammonium hydroxide, tetraethyl ammonium hydroxide, tetrabutyl ammonium hydroxide, monoethanolamine, diethanolamine, triethanolamine; and the like are included.

### EXAMPLE

The present invention is explained in further specifically below by means of Examples, however, not limited thereto.

### Example 1

Into a 3L flask equipped with a stirring apparatus and a refluxing condenser, 372 g (2 epoxy equivalent) of Epikote 828 (trade name of a bisphenol-A-type epoxy resin produced from Japan Epoxy Resins Co., Ltd., which has epoxy equivalent of 186 g/equivalent, as calculated theoretical value from structural formula), as a compound (e) having at least two glycidyl groups in a molecule, 144.1 g (2 moles) of acrylic acid (molecular weight=72.06) as a monocarboxylic acid (f) having an ethylenic unsaturated group in a molecule, 1.55 g of 2,6-ditertiary-butyl-p-cresol as a thermal polymerization inhibitor, and 1.55 g of triphenylphosphine as a reaction catalyst were charged, and they were subjected to a reaction at 100ºC for 22 hours to yield a polyol compound (c) containing an unsaturated group (2 hydroxyl group equivalent: theoretical value). Then, 1, 146 g of γ-butylolactone, as a solvent, and 436.2 g (2 moles) of pyromellitic anhydride (produced from Nippon Shokubai Co., Ltd.: molecular weight=218.12), as a tetrabasic acid dianhydride (d) were added to this resin, and subjected to a reaction at 100ºC for 10 hours to yield an unsaturated group-containing polyester resin (a) having a terminal anhydride group (2 anhydride group equivalent: theoretical value).

Subsequently the solution was cooled, and when temperature of the reaction solution reached to 10ºC, 193.5 g (0.97 mole) of 3,4'-diaminodiphenyl ether was added as a compound (b) having two amino groups in a molecule, and subjected to a reaction for 24 hours so that reaction temperature is not over 15ºC to yield a resin solution containing about 50% by weight of a polyamide acid resin (A) containing an unsaturated group of the present invention (this resin solution was named A-1). Equivalent of an ethylenic unsaturated group here was 570 g/equivalent, and equivalent of a carboxyl group was 310 g/equivalent.

### Example 2

Into a 3L flask equipped with a stirring apparatus and a refluxing condenser, 229.8 g of γ-butylolactone as a reaction solvent, 392 g (2 epoxy equivalent) of YX4000 (trade name of a bisxylenol-type epoxy resin produced from Japan Epoxy Resins Co., Ltd., which has epoxy equivalent of 196 g/equivalent, as calculated theoretical value from structural formula), as a compound (e) having at least two glycidyl groups in a molecule, 144.1 g (2 moles) of acrylic acid (molecular weight=72.06) as a monocarboxylic acid (f) having an ethylenic unsaturated group in a molecule, 1.55 g of 2,6-ditertiary-butyl-p-cresol as a thermal polymerization inhibitor, and 2.30 g of triphenylphosphine as a reaction catalyst were charged, and they were subjected to a reaction at 100ºC for 22 hours to yield a polyol compound (c) containing an unsaturated group (2 hydroxyl group equivalent: theoretical value). Then, 936 g of γ-butylolactone as a solvent, 436.2 g (2 moles) of pyromellitic anhydride (produced from Nippon Shokubai Co., Ltd.: molecular weight=218.12), as a tetrabasic acid dianhydride (d), were added to this resin, and subjected to a reaction at 100ºC for 10 hours to yield an unsaturated group-containing polyester resin (a) having a terminal anhydride group (2 anhydride group equivalent: theoretical value).

Subsequently the solution was cooled, and when temperature of the reaction solution reached to 10ºC, 193.5 g (0.97 mole) of 3,4'-diaminodiphenyl ether was added as a compound (b) having two amino groups in a molecule, and subjected to a reaction for 24 hours so that reaction temperature is not over 15ºC to yield a resin solution containing about 50% by weight of a polyamide acid resin (A) containing an unsaturated group of the present invention (this resin solution was named A-2). Equivalent of an ethylenic unsaturated group here was 580 g/equivalent, and equivalent of a carboxyl group was 380 g/equivalent.

### Example 3

Into a 3L flask equipped with a stirring apparatus and a refluxing condenser, 254.8 g of γ-butylolactone as a reaction solvent, 450.5 g(2 epoxy equivalent) of RE-203 (trade name of a bisphenol-S-type epoxy resin produced from Nippon Kayaku Co., Ltd., which has epoxy equivalent of 225.3 g/equivalent, as calculated theoretical value from structural formula), as a compound (e) having at least two glycidyl groups in a molecule, 144.1 g (2 moles) of acrylic acid (molecular weight=72.06) as a monocarboxylic acid (f) having an ethylenic unsaturated group in a molecule, 1.55 g of 2,6-ditertiary-butyl-p-cresol as a thermal polymerization inhibitor, and 2.55 g of triphenylphosphine as a reaction catalyst were charged, and they were subjected to a reaction at 100ºC for 22 hours to yield a polyol compound (c) containing an unsaturated group (2 hydroxyl group equivalent: theoretical value). Then, 969.5 g of γ -butylolactone as a solvent, 436.2 g (2 moles) of pyromellitic anhydride (produced from Nippon Shokubai Co. , Ltd. : molecular weight=218.12), as a tetrabasic acid dianhydride (d), were added to this resin, and subjected to a reaction at 100ºC for 10 hours to yield an unsaturated group-containing polyester resin (a) having a terminal anhydride group (2 anhydride group equivalent: theoretical value).

Subsequently the solution was cooled, and when temperature of the reaction solution reached to 10ºC, 193.5 g (0.97 mole) of 3,4'-diaminodiphenyl ether was added as a compound (b) having two amino groups in a molecule, and subjected to a reaction for 24 hours so that reaction temperature is not over 15ºC to yield a resin solution containing about 50% by weight of a polyamide acid resin (A) containing an unsaturated group of the present invention (this resin solution was named A-3). Equivalent of an ethylenic unsaturated group here was 610 g/equivalent, and equivalent of a carboxyl group was 410 g/equivalent.

### Example 4

Into a 3L flask equipped with a stirring apparatus and a refluxing condenser, 372 g (2 epoxy equivalent) of Epikote 828 (trade name of a bisphenol-A-type epoxy resin produced from Japan Epoxy Resins Co., Ltd., which has epoxy equivalent of 186 g/equivalent, as calculated theoretical value from structural formula), as a compound (e) having at least two glycidyl groups in a molecule, 144.1 g (2 moles) of acrylic acid (molecular weight=72.06) as a monocarboxylic acid (f) having an ethylenic unsaturated group in a molecule, 1.55 g of 2,6-ditertiary-butyl-p-cresol as a thermal polymerization inhibitor, and 1.55 g of triphenylphosphine as a reaction catalyst were charged, and they were subjected to a reaction at 100ºC for 22 hours to yield a polyol compound (c) containing an unsaturated group (2 hydroxyl group equivalents weight: theoretical value). Then, 1,354 g of γ-butylolactone, as a solvent, and 644.4 g (2 moles) of 3,3',4,4'-benzophenonetetracarboxylic dianhydride (molecular weight=322.2), as a tetrabasic acid dianhydride (d), were added to this resin, and subjected to a reaction at 100ºC for 10 hours to yield an unsaturated group-containing polyester resin (a) having a terminal anhydride group (2 anhydride group equivalent: theoretical value).

Subsequently the solution was cooled, and when temperature of the reaction solution reached to 10ºC, 193.5 g (0.97 mole) of 3,4'-diaminodiphenyl ether was added as a compound (b) having two amino groups in a molecule, and subjected to a reaction for 24 hours so that reaction temperature is not over 15ºC to yield a resin solution containing about 50% by weight of a polyamide acid resin (A) containing an unsaturated group of the present invention (this resin solution was named A-4). Equivalent of an ethylenic unsaturated group here was 680 g/equivalent, and equivalent of a carboxyl group was 440 g/equivalent.

### Example 5

Into a 3L flask equipped with a stirring apparatus and a refluxing condenser, 372 g (2 epoxy equivalent) of Epikote 828 (trade name of a bisphenol-A-type epoxy resin produced from Japan Epoxy Resins Co., Ltd., which has epoxy equivalent of 186 g/equivalent, as calculated theoretical value from structural formula), as a compound (e) having at least two glycidyl groups in a molecule, 144.1 g (2 moles) of acrylic acid (molecular weight=72.06) as a monocarboxylic acid (f) having an ethylenic unsaturated group in a molecule, 1.55 g of 2,6-ditertiary-butyl-p-cresol as a thermal polymerization inhibitor, and 1.55 g of triphenylphosphine as a reaction catalyst were charged, and they were subjected to a reaction at 100ºC for 22 hours to yield a polyol compound (c) containing an unsaturated group (2 hydroxyl group equivalents weight: theoretical value). Then, 1,160.5 g of γ-butylolactone, as a solvent, and 436.2 g (2 moles) of pyromellitic anhydride (produced from Nippon Shokubai Co., Ltd.: molecular weight=218.12), as a tetrabasic acid dianhydride (d), were added to this resin, and subjected to a reaction at 100ºC for 10 hours to yield an unsaturated group-containing polyester resin (a) having a terminal anhydride group (2 anhydride group equivalent: theoretical value).

Subsequently the solution was cooled, and when temperature of the reaction solution reached to 10ºC, 208.2 g (0.97 mole) of 4,4'-diaminodiphenylmethane was added as a compound (b) having two amino groups in a molecule, and subjected to a reaction for 24 hours so that reaction temperature is not over 15ºC to yield a resin solution containing about 50% by weight of a polyamide acid resin (A) containing an unsaturated group of the present invention (this resin solution was named A-5). Equivalent of an ethylenic unsaturated group here was 580 g/equivalent, and equivalent of a carboxyl group was 380 g/equivalent.

### Examples 6 to 10

Into each of the resin solutions (A-1), (A-2), (A-3), (A-4) and (A-5) obtained in the above Example 1, Example 2, Example 3, Example 4 and Example 5, respectively, other components shown in Table 1 were blended in each formulation ratio shown in Table 1, and mixed by a three roll mill, if necessary, to yield a photosensitive resin composition of the present invention. This was applied onto a copper printed-circuit board by a bar coating method, so as to obtain a thickness of 15 to 25 µm, then the coating film containing a solvent was dried in a hot-air dryer at 80ºC for 60 minutes. On the resultant dry coating film, tackiness was confirmed as described later. Then, a masking film drawn with patterns was closely contacted and subjected to irradiation of ultraviolet ray using "Ultraviolet ray exposure equipment" ("500 W Multi-light" produced from USHIO Co., Ltd.). Next, spraying development was carried out (under a spraying pressure of 0.2 MPa) for 60 seconds using a 2% by weight of aqueous solution of sodium carbonate (at a temperature of 30ºC). After washing with water, it was subjected to heat treatment in a hot-air dryer at 150ºC for 40 minutes to yield a cured product of the present invention. On the resultant cured film, photosensitivity, surface gloss, adhesiveness, pencil hardness, solvent resistance, acid resistance and gold plating resistance were tested, as described later. Furthermore, the resultant cured product was heated from 150ºC up to 350ºC over 2 hours, and heat-treated at 350ºC for 2 hours to be subjected to tests of substrate warpage, flexibility and heat resistance. Results of these tests are shown in Table 2. Test methods and evaluation standards are as follows:

(Tackiness) The resultant dry coating film above was cooled to room temperature, and then absorbent cotton was rubbed thereon to evaluate tackiness thereof.
Good(G): Absorbent cotton does not adhere.
Poor(P): Yarn waste of absorbent cotton adheres on the film.

(photosensitivity) Dried coating film was irradiated by ultraviolet ray and then developed to confirm whether a cured product was yielded or not. The standard below was used.
Good(G): It was cured even at an irradiation intensity of not higher than 500 mJ/cm².
Poor(P) : It was only cured at an irradiation intensity of not lower than 500 mJ/cm².

(Surface gloss) Dried coating film was irradiated by ultraviolet ray of 500 mJ/cm² and then yielded a cured film by the above method. The resultant cured film was immersed in ethanol for 60 seconds and dried to observe the state of the cured film. The standard below was used.
Good(G): No cloudiness observed
Average (A): A little cloudiness observed
Poor(P): Cloudiness without gloss observed

(Adhesiveness) Dried coating film was irradiated by ultraviolet ray of 500 mJ/cm² and then yielded a cured film by the above method. The resultant cured film was subjected to the peeling test in accordance with JIS K5400, using "Sellotape" (trade name) on 100 crosscuts of 1 mm size at the test piece. Peeling state of the crosscuts was observed and evaluated by the following standard.
Good(G): No peeling off observed
Poor(P): Peeling off observed

(Pencil hardness) Dried coating film was irradiated by ultraviolet ray of 500 mJ/cm² and then yielded a cured film by the above method. The resultant cured film was evaluated in accordance with JIS K5400.

(Solvent resistance) Dried coating film was irradiated by ultraviolet ray of 500 mJ/cm² and then yielded a cured film by the above method. The resultant cured film was immersed in isopropyl alcohol at room temperature for 30 minutes to confirm whether abnormal appearance was present or not.
Good(G): No cloudiness observed at all
Poor(P): A little cloudiness observed

(Acid resistance) Dried coating film was irradiated by ultraviolet ray of 500 mJ/cm² and then yielded a cured film by the above method. The resultant cured film was immersed in a 10% by weight aqueous solution of hydrochloric acid at room temperature for 30 minutes to confirm whether abnormal appearance was present or not. Then, it was subjected to the peeling test using "Sellotape" (trade name) to evaluate by the following standard.
Good(G): No abnormal film appearance, swell or peeling observed
Poor(P): Swell or peeling of the film observed

(Gold plating resistance) Dried coating film was irradiated by ultraviolet ray at 500 mJ/cm² and then yielded a cured film by the above method. A test substrate of the resultant cured film was immersed in an acidic degreasing solution (a 20% by volume aqueous solution of Metex L-5B (trade name) produced from Japan Macdermit Co., Ltd.) at 30ºC for 3 minutes, washed with water, then immersed in a 14.4% by weight aqueous solution of ammonium persulfate at room temperature for 3 minutes, washed with water, further immersed in a 10% by volume aqueous solution of sulfuric acid at room temperature for 1 minute and then washed with water. Then this substrate was immersed in a catalyst solution (a 10% by volume aqueous solution of Metal plate Activator 350 (trade name) produced from Meltex Co., Ltd.) at 30ºC for 7 minutes, washed with water, immersed in a nickel plating solution (a 20% by volume aqueous solution of Melplate Ni-865M (trade name) produced from Meltex Co., Ltd.: pH=4.6) at 85ºC for 20 minutes, to carry out nickel plating, then further immersed in a 10% by volume aqueous solution of sulfuric acid at room temperature for 1 minute and washed with water. Then the test substrate was immersed in a gold plating solution (produced from Meltex Co., Ltd.: an aqueous solution of 15% by volume of Aurolectroless UP (trade name) and 3% by volume of potassium gold cyanide: pH=6) at 95ºC for 10 minutes to carry out electroless gold plating, washed with water, further immersed in hot water at 60ºC for 3 minutes, washed with water and dried. The resultant evaluation substrate for electroless gold plating was adhered with a "Sellotape" pressure sensitive adhesives tape and observed the state in peeling thereof.
Good(G): No abnormal appearance observed at all
Poor(P): A little peeling observed.

(Substrate warpage) The following standard was used.
Good(G): No substrate warpage observed.
Average (A): A little substrate warpage observed.
Poor(P): Substrate warpage observed.

(Flexibility) The cured film appearance was observed by bending in 180 degree. The following standard was used.
Good(G): No crack at the film surface observed.
Poor(P): Crack was observed at the film surface.

(Heat resistance) The cured film was applied with rosin-based flux and immersed in a soldering tank at 260ºC for 5 seconds. This cycle of procedure was repeated 3 times. The film was cooled to room temperature and then subjected to the peeling test using "Sellotape" (trade name) to evaluate by the following standard.
Good(G): No abnormal film appearance, swell or peeling observed.
Poor(P): Swell or peeling of the film observed.

**Table 1**

| | Exp.6 | Exp.7 | Exp.8 | Exp.9 | Exp. 10 |
|---|---|---|---|---|---|
| (A) | | | | | |
| A-1 | 38.15 | | | | |
| A-2 | | 38.15 | | | |
| A-3 | | | 38.15 | | |
| A-4 | | | | 38.15 | |
| A-5 | | | | | 38.15 |

| (B) | | | | | |
|---|---|---|---|---|---|
| DPHA (*1) | 5.16 | 5.16 | 5.16 | 5.16 | 5.16 |
| TMPTA (*2) | 2.00 | 2.00 | 2.00 | 2.00 | 2.00 |

| (C) | | | | | |
|---|---|---|---|---|---|
| Irg 907 (*3) | 3.58 | 3.58 | 3.58 | 3.58 | 3.58 |
| DETX-S (*4) | 0.36 | 0.36 | 0.36 | 0.36 | 0.36 |

| (D) | | | | | |
|---|---|---|---|---|---|
| YX4000 (*5) | 3.58 | 3.58 | 3.58 | 3.58 | 3.58 |
| TEPIC (*6) | 7.16 | 7.16 | 7.16 | 7.16 | 7.16 |
| Additives Melamine | 1.07 | 1.07 | 1.07 | 1.07 | 1.07 |
| Silica | 7.88 | 7.88 | 7.88 | 7.88 | 7.88 |
| Barium sulfate | 17.53 | 17.53 | 17.53 | 17.53 | 17.53 |
| Pigment | 0.47 | 0.47 | 0.47 | 0.47 | 0.47 |
| BYK-354 (*7) | 0.72 | 0.72 | 0.72 | 0.72 | 0.72 |
| KS-66 (*8) | 0.72 | 0.72 | 0.72 | 0.72 | 0.72 |

| (E) | | | | | |
|---|---|---|---|---|---|
| PGMEA (*9) | 11.62 | 11.62 | 11.62 | 11.62 | 11.62 |

| | | | | | |
|---|---|---|---|---|---|
| (Note) | | | | | |
| (A): a polyamide acid resin (A) containing an unsaturated group | | | | | |
| (B): a crosslinker (B) | | | | | |
| (C): a photopolymerization initiator (C) | | | | | |
| (D): a component to be cured | | | | | |
| (E): a solvent for concentration adjustment | | | | | |
| *1 dipentaerythritol hexaacrylate (produced from Nippon Kayaku Co., Ltd.) | | | | | |
| *2 trimethylolpropane triacrylate (produced from Nippon Kayaku Co., Ltd.) | | | | | |
| *3 2-methyl-1-[4-(methylthio)phenyl]-2-morpholinopropane-1-one (produced from Ciba Specialty Chemicals Co., Ltd.) | | | | | |
| *4 2,4-diethylthioxanthon (produced from Nippon Kayaku Co., Ltd.) | | | | | |
| *5 a bixylenol-type epoxy resin (produced from Japan Epoxy Resins Co., Ltd.) | | | | | |
| *6 a heterocyclic epoxy resin (produced from Nissan Chemical Industries, Ltd.) | | | | | |
| *7 a leveling agent (produced from Bick Chemie Co., Ltd.) | | | | | |
| *8 an antifoaming agent (produced from Shin-Etsu Chemical Co. , Ltd.) | | | | | |
| *9 propylene glycol monomethyl ether acetate | | | | | |

**Table 2**

| Evaluation Items | Exp. 6 | Exp. 7 | Exp. 8 | Exp. 9 | Exp. 10 |
|---|---|---|---|---|---|
| Tackiness | G | G | G | G | G |
| Photosensitivity | G | G | G | G | G |
| Surface gloss | G | A | G | A | G |
| Adhesiveness | G | G | G | G | G |
| Pencil hardness | 5H | 7H | 6H | 5H | 5H |
| Solvent resistance | G | G | G | G | G |
| Acid resistance | G | G | G | G | G |
| Gold plating resistance | G | G | G | G | G |
| Substrate warpage | G | G | G | G | G |
| Flexibility | G | G | G | G | G |
| Heat resistance | G | G | G | G | G |

| | | | | | |
|---|---|---|---|---|---|
| (Note) G: Excellent, A: Average, (P: Poor) | | | | | |

As clear from Table 2, a photosensitive resin composition of the present invention has no tackiness and is excellent in photosensitivity, and a cured film thereof also is excellent in flexibility as well as soldering heat resistance, chemical resistance, gold plating resistance, and the like, and is therefore suitable, in particular, as a photosensitive resin composition for a printed circuit board.

### INDUSTRIAL APPLICABILITY

A photosensitive resin composition of the present invention is excellent in photosensitivity, in forming a coating film by means of ultraviolet ray exposure curing, and the resultant cured product is excellent in flexibility, as well as sufficiently satisfies adhesiveness, pencil hardness, solvent resistance, acid resistance, heat resistance, gold plating resistance, and the like, and therefore can suitably be used as photocuring-type paint, photocuring-type adhesives, and the like, and is suitable, in particular, as a photosensitive resin composition for a printed circuit board.

## Claims

1. A polyamide acid resin (A) containing an unsaturated group, obtained by reacting an unsaturated group-containing polyester resin (a) having a terminal anhydride group with a compound (b) having two amino groups in a molecule.

2. The polyamide acid resin (A) containing an unsaturated group according to Claim 1, wherein an unsaturated group-containing polyester resin (a) having a terminal anhydride group is a compound obtained by reacting a polyol compound (c) containing an unsaturated group with a tetrabasic acid dianhydride (d).

3. The polyamide acid resin (A) containing an unsaturated group according to Claim 2, wherein a polyol compound (c) containing an unsaturated group is a compound obtained by reacting a compound (e) having at least two glycidyl groups in a molecule with a monocarboxylic acid (f) having an ethylenic unsaturated group in a molecule.

4. The polyamide acid resin (A) containing an unsaturated group according to Claim 3, wherein a compound (e) having at least two glycidyl groups in a molecule is (1) a bisphenol-type epoxy resin, (2) a straight chain or cyclic (C2 to C10) aliphatic polyvalent glycidyl ether, provided that number of a glycidyl group is 2 to 5, and number of carbon atoms in the case of a cyclic ether is at least 3, (3) a polysulfide type diglycidyl ether, or (4) a biphenol-type diepoxy compound, and in addition, a monocarboxylic acid (f) having an ethylenic unsaturated group in a molecule is a (C3 to C6) aliphatic monocarboxylic acid containing an ethylenic unsaturated group which may be substituted with a phenyl group.

5. The polyamide acid resin (A) containing an unsaturated group according to Claim 3, wherein a compound (e) having at least two glycidyl groups in a molecule is a compound selected from a group of a phenyl diglycidyl ether compound, a bisphenol-type diepoxy compound, a hydrogenated bisphenol-type diepoxy compound, a halogenated bisphenol-type diepoxy compound, an alicyclic diepoxy compound, an aliphatic diglycidyl ether compound, a polysulfide-type diglycidyl ether compound and a biphenol-type diepoxy compound.

6. The polyamide acid resin (A) containing an unsaturated group according to Claim 4 or Claim 5, wherein a monocarboxylic acid (f) having an ethylenic unsaturated group in a molecule is (meth)acrylic acid or cinnamic acid.

7. The polyamide acid resin (A) containing an unsaturated group according to any one of Claims 2 to 6, wherein a tetrabasic acid dianhydride (d) is a tetrabasic acid dianhydride selected from a group consisting of pyromellitic dianhydride, ethylene glycol-bis(anhydrotrimellitate), glycerin bis(anhydrotrimellitate) monoacetate, 1,2,3,4-butanetetracarboxylic dianhydride, 3,3',4,4'-diphenylsulfonetetracarboxylic dianhydride, 3,3',4,4'-benzophenonetetracarbaxylic dianhydride, 3,3',4,4'-biphenyltetracarboxylic dianhydride, 3,3',4,4'-diphenylethertetracarboxylic dianhydride, 2,2-bis(3,4-anhydrodicarboxyphenyl)propane, 2,2-bis(3,4-anhydrodicarboxyphenyl)hexafluoropropane, 5-(2,5-dioxotetrahydro-3-furanyl)-3-methylcyclohexene-1,2-dicarboxylic anhydride, and 3a,4,5,9b-tetrahydro-5-(tetrahydro-2,4-dioxo-3-furanyl)-naphtho[1,2-c]furan-1,3-dione.

8. The polyamide acid resin (A) containing an unsaturated group according to any one of Claims 1 to 7 , wherein a compound (b) having two amino groups in a molecule is a compound selected from a group consisting of 4,4'-diaminodiphenylmethane, 3,4'-diaminodiphenylmethane, 4,4'-diaminodiphenylether, 3,4'-diaminodiphenylether, 4,4'-diaminodiphenylsulfone, 3,4'-diaminodiphenylsulfone, 4,4'-diaminobenzophenone, and 3,4'-diaminobenzophenone.

9. The polyamide acid resin (A) containing an unsaturated group according to any one of Claims 1 to 6, wherein equivalent of an ethylenic unsaturated group of a polyamide acid resin (A) containing an unsaturated group is 300 to 2,000 g/ equivalent.

10. The polyamide acid resin (A) containing an unsaturated group according to any one of Claims 1 to 8, wherein equivalent of a carboxyl group of a polyamide acid resin (A) containing an unsaturated group is 200 to 1,500 g/equivalent.

11. A method for producing a polyamide acid resin (A) containing an unsaturated group according to any one of Claims 1 to 10, **characterized by** reacting a polyol compound (c) containing an unsaturated group, which is a reaction product of a compound (e) having at least two glycidyl groups in a molecule and a monocarboxylic acid (f) having an ethylenic unsaturated group in a molecule, and a tetrabasic acid dianhydride (d) to yield an unsaturated group-containing polyester resin (a) having a terminal anhydride group, which is then reacted with a compound (b) having two amino groups in a molecule.

12. The method for producing the polyamide acid resin (A) containing an unsaturated group according to Claim 11, wherein a compound (e) having at least two glycidyl groups in a molecule is a bisphenol-type diepoxy compound, or a biphenol-type diepoxy compound; a monocarboxylic acid (f) having an ethylenic unsaturated group in a molecule is acrylic acid; a tetrabasic acid dianhydride (d) is pyromellitic anhydride or 3,3',4,4'-benzophenone tetracarboxylic dihydride; and a compound (b) having two amino groups in a molecule is 3,4'-diaminodiphenyl ether.

13. A photosensitive resin composition **characterized by** containing the polyamide acid resin (A) containing an unsaturated group according to any one of Claims 1 to 12, a crosslinker (B) and a photopolymerization initiator (C).

14. The photosensitive resin composition **characterized by** containing the polyamide acid resin (A) containing an unsaturated group according to any one of Claims 1 to 12, a crosslinker (B), a photopolymerization initiator (C), and a component (D) to be cured.

15. A cured product of the photosensitive resin composition according to Claim 13 or Claim 14.

16. A substrate having a layer of the cured product according to Claim 15.

17. An article having the substrate according to Claim 16.
